(19) Europäisches Patentamt / European Patent Office / Office européen des brevets

(11) **EP 4 268 293 B1**

(12) **FASCICULE DE BREVET EUROPEEN**

(45) Date de publication et mention
de la délivrance du brevet:
**04.12.2024   Bulletin 2024/49**

(21) Numéro de dépôt: **21839473.2**

(22) Date de dépôt: **15.12.2021**

(51) Classification Internationale des Brevets (IPC):
***H10K 50/805*** *(2023.01)*    ***H10K 59/80*** *(2023.01)*

(52) Classification Coopérative des Brevets (CPC):
**H10K 59/8793;** H10K 59/80515; H10K 59/80521;
H10K 59/879

(86) Numéro de dépôt international:
**PCT/EP2021/085886**

(87) Numéro de publication internationale:
**WO 2022/136051 (30.06.2022 Gazette 2022/26)**

(54) **DISPOSITIF ELECTROLUMINESCENT**

ELEKTROLUMINESZENTE VORRICHTUNG

ELECTROLUMINESCENT DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **22.12.2020   FR 2013919**

(43) Date de publication de la demande:
**01.11.2023   Bulletin 2023/44**

(73) Titulaire: **Commissariat à l'Energie Atomique et
aux Energies
Alternatives
75015 Paris (FR)**

(72) Inventeurs:
• **RACINE, Benoit
38054 GRENOBLE Cedex 09 (FR)**
• **LE BLEVENNEC, Gilles
38054 GRENOBLE Cedex 09 (FR)**
• **QUESNEL, Etienne
38054 GRENOBLE Cedex 09 (FR)**

(74) Mandataire: **INNOV-GROUP
209 Avenue Berthelot
69007 Lyon (FR)**

(56) Documents cités:
| | |
|---|---|
| JP-A- 2000 195 673 | JP-A- 2003 163 087 |
| KR-A- 20190 075 218 | US-A1- 2009 021 153 |
| US-A1- 2010 271 566 | US-A1- 2011 001 905 |
| US-A1- 2014 326 956 | US-B2- 8 247 834 |

## Description

## Domaine technique

L'invention se rapporte au domaine technique des dispositifs électroluminescents, notamment organiques. Plus précisément, l'invention vise à obtenir un dispositif électroluminescent émettant un rayonnement électromagnétique polarisé circulairement avec un fort degré de polarisation.

L'invention trouve notamment son application dans l'imagerie en biologie et plus généralement dans le domaine de la santé, ou encore dans les afficheurs 2D et 3D.

## État de l'art

Un dispositif électroluminescent organique connu de l'état de la technique, notamment du document Zinna et al., « Higbly Circularly Polarized Electroluminescence from a Chiral Europium Complex », Advanced Materials, vol.27, n°10, 2015, comporte :

- une première électrode, réfléchissante, réalisée en aluminium ;
- une seconde électrode, transparente, réalisée en ITO (« *Indium Tin Oxide* » en langue anglaise) ;
- une couche électroluminescente organique, formée entre les première et seconde électrodes, et adaptée pour émettre un rayonnement électromagnétique polarisé circulairement selon un premier sens de polarisation.

Un tel dispositif de l'état de la technique ne permet pas d'émettre un rayonnement électromagnétique polarisé circulairement, avec un fort degré de polarisation, en sortie de la seconde électrode.

En effet, la partie du rayonnement électromagnétique émis par la couche électroluminescente organique qui se réfléchit sur la première électrode possède un second sens de polarisation, opposé au premier sens de polarisation. Or, le degré de polarisation, noté g, vérifie la relation suivante :

$$g = 2\frac{I_L - I_R}{I_L + I_R}$$

où :

- $I_R$ est l'intensité du rayonnement électromagnétique, polarisé circulairement selon le premier sens de polarisation, en sortie de la seconde électrode,
- $I_L$ est l'intensité du rayonnement électromagnétique, polarisé circulairement selon le second sens de polarisation, en sortie de la seconde électrode.

La réflexion de la partie du rayonnement électromagnétique émis par la couche électroluminescente organique sur la première électrode conduit à réduire le degré de polarisation g car $I_L$ est du même ordre de grandeur que $I_R$.

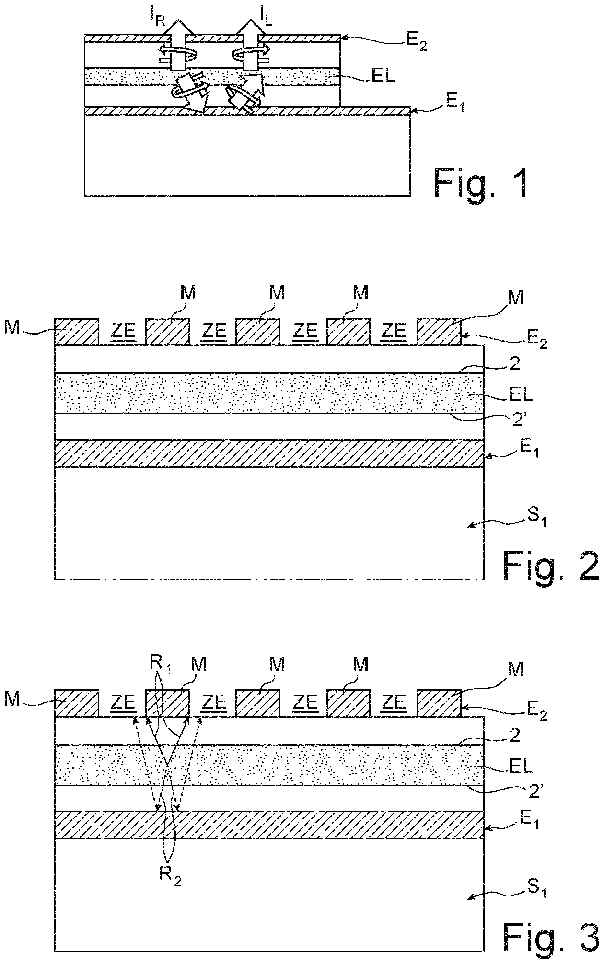

De plus, comme illustré à la figure 1 pour une architecture à émission vers le haut, un dispositif électroluminescent organique connu de l'état de la technique comporte :

- une première électrode $E_1$, réfléchissante ;
- une seconde électrode $E_2$, semi-transparente ;
- une couche électroluminescente EL organique, formée entre les première et seconde électrodes $E_1$, Ez, et adaptée pour émettre un rayonnement électromagnétique polarisé circulairement selon un premier sens de polarisation.

De la même façon, un tel dispositif de l'état de la technique ne permet pas d'émettre un rayonnement électromagnétique polarisé circulairement, avec un fort degré de polarisation, en sortie de la seconde électrode Ez. En effet, la partie du rayonnement électromagnétique émis par la couche électroluminescente EL organique qui se réfléchit sur la première électrode $E_1$ possède un second sens de polarisation, opposé au premier sens de polarisation. La réflexion de la partie du rayonnement électromagnétique émis par la couche électroluminescente EL organique sur la première électrode $E_1$ conduit à réduire le degré de polarisation g car $I_L$ est du même ordre de grandeur que $I_R$.

KR 2019 0075218 A, JP 2000 195673 A, US 20111001905 A1 et US 8 247 834 B2 décrivent d'autres dispositifs de l'art antérieur.

## Exposé de l'invention

L'invention vise à remédier en tout ou partie aux inconvénients précités. A cet effet, l'invention a pour objet un dispositif électroluminescent, comportant :

- une première électrode, réfléchissante dans un domaine spectral ;
- une seconde électrode ;
- une couche électroluminescente, s'étendant entre les première et seconde électrodes, et adaptée pour émettre un rayonnement électromagnétique dans le domaine spectral, le rayonnement électromagnétique émis par la couche électroluminescente étant polarisé circulairement selon un premier sens de polarisation, le rayonnement électromagnétique réfléchi par la première électrode étant polarisé circulairement selon un second sens de polarisation, opposé au premier sens de polarisation ;

remarquable en ce que la seconde électrode est structurée de manière à délimiter :

- des motifs opaques dans le domaine spectral, agencés pour bloquer une transmission du rayonnement électromagnétique polarisé circulairement selon le premier sens de polarisation ;

- une zone d'espacement, espaçant les motifs opaques entre eux, et transparente dans le domaine spectral de manière à autoriser une transmission du rayonnement électromagnétique polarisé circulairement selon le second sens de polarisation.

Définitions

- Par « réfléchissante », on entend que la première électrode possède un coefficient de réflexion en intensité, moyenné sur le domaine spectral, supérieur ou égal à 70%, de préférence supérieur ou égal à 80%, plus préférentiellement supérieur ou égal à 90%.
- L'expression « s'étendant entre » n'implique pas nécessairement que la couche électroluminescente se trouve en contact avec les première et seconde électrodes. Le dispositif peut par exemple comporter des couches de transport (d'électrons et de trous) et des couches d'injection (d'électrons et de trous) s'étendant entre une électrode et la couche électroluminescente (dite couche émissive).
- L'expression « polarisé circulairement » peut également couvrir un état de polarisation en toute rigueur elliptique lorsque les composantes du champ électrique (ou magnétique) sont très légèrement différentes en intensité lors de la propagation du rayonnement électromagnétique.
- Par « structurée », on entend que la seconde électrode présente des ruptures de planéité délimitant un ensemble de motifs.
- Par « opaques », on entend que les motifs possèdent un coefficient de transmission en intensité, moyenné sur le domaine spectral, inférieur ou égal à 10%, de préférence inférieur ou égal à 5%, plus préférentiellement inférieur ou égal à 1% voire tendre vers 0%.
- Par « transparente », on entend que la zone d'espacement possède un coefficient de transmission en intensité, moyenné sur le domaine spectral, supérieur ou égal à 70%, de préférence supérieur ou égal à 80%, plus préférentiellement supérieur ou égal à 90%.

Ainsi, un tel dispositif selon l'invention permet d'émettre un rayonnement électromagnétique polarisé circulairement selon le second sens de polarisation, avec un fort degré de polarisation, en sortie de la seconde électrode structurée.

En d'autres termes, on a $I_L > > I_R$ où :

- $I_R$ est l'intensité du rayonnement électromagnétique, polarisé circulairement selon le premier sens de polarisation, en sortie de la seconde électrode structurée,
- $I_L$ est l'intensité du rayonnement électromagnétique, polarisé circulairement selon le second sens de polarisation (opposé au premier sens de polarisation), en sortie de la seconde électrode structurée.

$I_R$ est issue de la propagation directe du rayonnement électromagnétique émis depuis la couche électroluminescente vers la seconde électrode structurée. $I_L$ est issue de la propagation du rayonnement électromagnétique émis depuis la couche électroluminescente vers la première électrode, et subissant une réflexion sur la première électrode.

$I_R$ est très faible devant $I_L$ car la propagation directe du rayonnement électromagnétique, émis depuis la couche électroluminescente vers la seconde électrode structurée, est bloquée par les motifs opaques de la seconde électrode structurée. Or, la propagation du rayonnement électromagnétique émis depuis la couche électroluminescente vers la première électrode, et subissant une réflexion sur la première électrode, est quant à elle autorisée dans la zone d'espacement de la seconde électrode structurée. Il en résulte que le rayonnement électromagnétique sortant de la seconde électrode structurée est très majoritairement polarisé circulairement selon le second sens de polarisation.

Le dispositif selon l'invention peut comporter une ou plusieurs des caractéristiques suivantes.

Selon une caractéristique de l'invention, le rayonnement électromagnétique émis par la couche électroluminescente comporte des rayons, orientés vers la seconde électrode structurée, et formant des cônes de réfraction présentant chacun une base ; et les motifs opaques sont agencés de manière à recouvrir tout ou partie des bases des cônes de réfraction.

Définitions

- Par « cône de réfraction », on entend le cône dont le demi-angle au sommet correspond à l'angle critique $\theta_c$, calculé par la loi de Snell-Descartes pour la réfraction, au-delà duquel les rayons subissent une réflexion totale lors du passage d'un dioptre entre la couche électroluminescente et la seconde électrode structurée.

- Par « base », on entend la courbe directrice du cône de réfraction.

Ainsi, un avantage procuré par un tel agencement des motifs opaques est d'obtenir un blocage (total ou partiel) de la propagation directe du rayonnement électromagnétique émis depuis la couche électroluminescente vers la seconde électrode structurée. Le blocage peut être total lorsque les motifs opaques recouvrent entièrement les bases des cônes de réfraction, et lorsque les motifs opaques possèdent un coefficient de transmission en intensité très faible (par exemple inférieur à 1%).

Selon une caractéristique de l'invention, la couche électroluminescente comporte une première surface émissive orientée vers la seconde électrode structurée, et les motifs opaques occupent une surface totale possédant une aire comprise entre 30% et 70% de l'aire de la première surface émissive.

Ainsi, un avantage procuré par un tel taux de recouvrement des motifs opaques est d'obtenir un bon compromis entre :

- le blocage (par les motifs opaques) de la propagation directe du rayonnement électromagnétique émis depuis la couche électroluminescente vers la seconde électrode structurée,
- la transmission (dans la zone d'espacement) de la propagation du rayonnement électromagnétique émis depuis la couche électroluminescente vers la première électrode, et subissant une réflexion sur la première électrode.

Selon une caractéristique de l'invention, la première électrode comporte des motifs réfléchissants dans le domaine spectral, agencés pour former un réseau de diffraction en réflexion, et dimensionnés pour moduler l'amplitude du rayonnement électromagnétique de sorte que :

- le réseau de diffraction en réflexion réfléchit uniquement l'ordre zéro d'interférences du rayonnement électromagnétique,
- le rayonnement électromagnétique sortant du réseau de diffraction en réflexion se propage en incidence normale.

Ainsi, un avantage procuré par un tel réseau de diffraction en réflexion est de contrôler la direction de propagation du rayonnement électromagnétique polarisé circulairement selon le second sens de polarisation (après réflexion sur les motifs réfléchissants) afin de positionner au mieux la zone d'espacement pour augmenter son extraction.

Selon une caractéristique de l'invention, le dispositif comporte un réseau de diffraction en transmission, comprenant des motifs transparents dans le domaine spectral, dimensionnés pour moduler la phase du rayonnement électromagnétique de manière à contrôler l'état de polarisation circulaire du rayonnement électromagnétique sortant du réseau de diffraction en transmission.

Ainsi, un avantage procuré par un tel réseau de diffraction en transmission est de pouvoir modifier la résultante des états de polarisation intégrés sur l'aire de la première surface émissive de la couche électroluminescente. Il est ainsi possible de contrôler l'état de polarisation circulaire du rayonnement électromagnétique sortant du réseau de diffraction en transmission de manière à obtenir un état polarisé circulairement selon le second sens de polarisation en sortie de la seconde électrode structurée, et ce afin d'augmenter son extraction.

Selon une caractéristique de l'invention, le réseau de diffraction en transmission est agencé selon une position choisie parmi :

- une première position, située entre la première électrode et la couche électroluminescente ;
- une deuxième position, située entre la couche électroluminescente et la seconde électrode structurée ;
- une troisième position, située sur la seconde électrode structurée.

Selon une caractéristique de l'invention, la seconde électrode structurée est réalisée dans un matériau composite comportant une matrice métallique et un renfort en céramique.

Ainsi, un avantage procuré est d'allier une bonne opacité, grâce au renfort céramique, et une bonne conduction électrique, grâce à la matrice métallique.

Selon une caractéristique de l'invention, les motifs opaques sont électriquement conducteurs, et la zone d'espacement forme des fentes agencées périodiquement de sorte que la seconde électrode structurée possède une surface sélective en fréquence de type filtre passe-bande.

Ainsi, un avantage procuré par une telle surface sélective en fréquence (FSS pour « *Frequency-Selective Surface* » en langue anglaise) est de pouvoir filtrer certaines fréquences du domaine spectral.

Selon une caractéristique de l'invention, les fentes présentent chacune une section transversale en forme de la lettre oméga majuscule $\Omega$.

Définition

Par « transversale », on entend une section qui coupe perpendiculairement l'axe optique du dispositif électroluminescent, autrement dit une section suivant une direction perpendiculaire à la normale aux surfaces émissives de la couche électroluminescente.

Ainsi, un avantage procuré est de renforcer la chiralité du rayonnement électromagnétique émis par la couche électroluminescente, par exemple lorsque celle-ci est réalisée dans un matériau organique chiral.

Selon une caractéristique de l'invention, la première électrode est réalisée dans un matériau métallique.

Selon une caractéristique de l'invention, la couche électroluminescente est réalisée dans un matériau organique chiral.

Selon une caractéristique de l'invention, le domaine spectral est choisi parmi :

- le domaine visible avec des longueurs d'onde comprises entre 400 nm et 780 nm,
- le domaine UV-A avec des longueurs d'onde comprises entre 315 nm et 400 nm,
- le domaine infrarouge proche avec des longueurs d'onde comprises entre 780 nm et 3 µm.

**Brève description des dessins**

D'autres caractéristiques et avantages apparaîtront dans l'exposé détaillé de différents modes de réalisation de l'invention, l'exposé étant assorti d'exemples et de références aux dessins joints.

Figure 1 (déjà commentée) est une vue schématique en coupe d'un dispositif électroluminescent de l'état de la technique.

Figure 2 est une vue schématique en coupe d'un dispositif électroluminescent selon l'invention, selon une architecture à émission vers le haut.

Figure 3 est une vue analogue à la figure 2, à l'échelle agrandie, illustrant des rayons bloqués par les motifs opaques et des rayons transmis dans la zone d'espacement.

Figure 4 est une vue schématique explicative en coupe, illustrant un cône de réfraction du rayonnement électromagnétique émis par la couche électroluminescente, et l'angle critique au-delà duquel les rayons subissent une réflexion totale lors du passage d'un dioptre entre la couche électroluminescente et la seconde électrode structurée.

Figure 5 est une vue schématique partielle de dessus d'un dispositif électroluminescent selon l'invention.

Figure 6 est une vue schématique en coupe d'un dispositif électroluminescent selon l'invention, selon une architecture à émission vers le bas.

Figure 7 est une vue schématique en coupe d'un dispositif électroluminescent selon l'invention, selon une architecture à émission vers le haut, illustrant un mode de réalisation où la première électrode comporte des motifs réfléchissants formant un réseau de diffraction en réflexion.

Figure 8 est une vue analogue à la figure 7, illustrant en outre la présence d'un réseau de diffraction en transmission et d'une couche d'encapsulation.

Figure 9 est une vue schématique de dessus d'une seconde électrode structurée possède une surface sélective en fréquence de type filtre passe-bande. L'encart illustre, à l'échelle agrandie, un motif de fente en forme de la lettre oméga majuscule $\Omega$.

Il est à noter que les dessins décrits ci-avant sont schématiques, et ne sont pas à l'échelle par souci de lisibilité et pour en simplifier leur compréhension. Les coupes sont effectuées suivant la normale aux surfaces émissives de la couche électroluminescente.

**Exposé détaillé des modes de réalisation**

Les éléments identiques ou assurant la même fonction porteront les mêmes références pour les différents modes de réalisation, par souci de simplification.

Un objet de l'invention est un dispositif électroluminescent, comportant :

- une première électrode $E_1$, réfléchissante dans un domaine spectral ;
- une seconde électrode $E_2$ ;
- une couche électroluminescente EL, s'étendant entre les première et seconde électrodes $E_1$, $E_2$, et adaptée pour émettre un rayonnement électromagnétique dans le domaine spectral, le rayonnement électromagnétique émis par la couche électroluminescente EL étant polarisé circulairement selon un premier sens de polarisation, le rayonnement électromagnétique réfléchi par la première électrode $E_1$ étant polarisé circulairement selon un second sens de polarisation, opposé au premier sens de polarisation ;

remarquable en ce que la seconde électrode $E_2$ est structurée de manière à délimiter :

- des motifs opaques M dans le domaine spectral, agencés pour bloquer une transmission du rayonnement électromagnétique polarisé circulairement selon le premier sens de polarisation ;
- une zone d'espacement ZE, espaçant les motifs opaques M entre eux, et transparente dans le domaine spectral de manière à autoriser une transmission du rayonnement électromagnétique polarisé circulairement selon le second sens de polarisation.

Première électrode

La première électrode $E_1$ est avantageusement réalisée dans un matériau métallique. Le matériau métallique est de préférence choisi parmi Ag, Al, Cr, Co, Be.

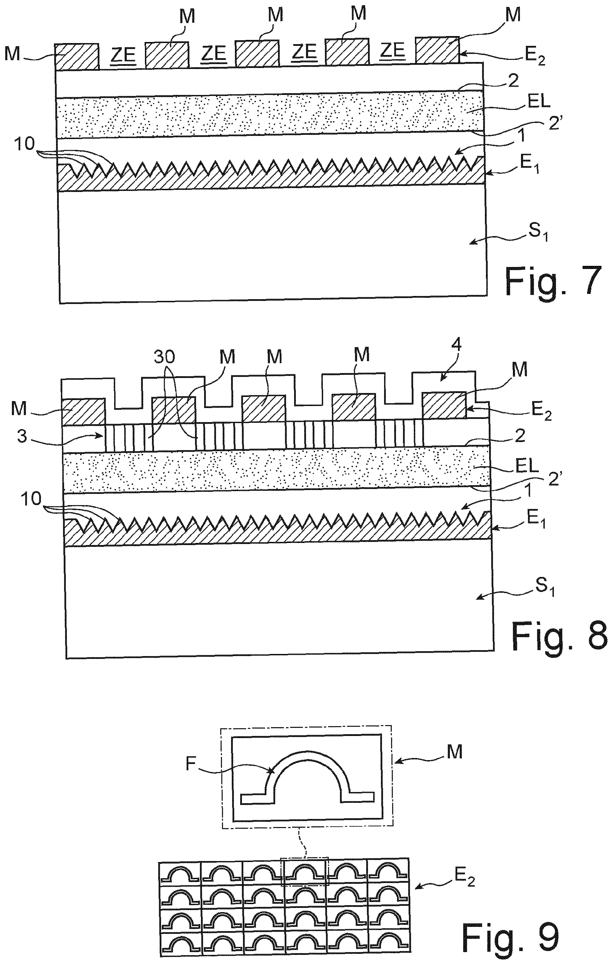

Comme illustré aux figures 7 et 8, la première électrode $E_1$ comporte avantageusement des motifs réfléchissants 10 dans le domaine spectral, agencés pour former un réseau de diffraction en réflexion 1, et dimensionnés pour moduler l'amplitude du rayonnement électromagnétique de sorte que :

- le réseau de diffraction en réflexion 1 réfléchit uniquement l'ordre zéro d'interférences du rayonnement électromagnétique,
- le rayonnement électromagnétique sortant du réseau de diffraction en réflexion 1 se propage en incidence normale.

Le dimensionnement et la période des motifs réfléchissants 10 peuvent être calculés à l'aide d'un logiciel de simulation utilisant notamment la formule des réseaux de diffraction en réflexion, connue de l'homme du métier.

## Seconde électrode structurée

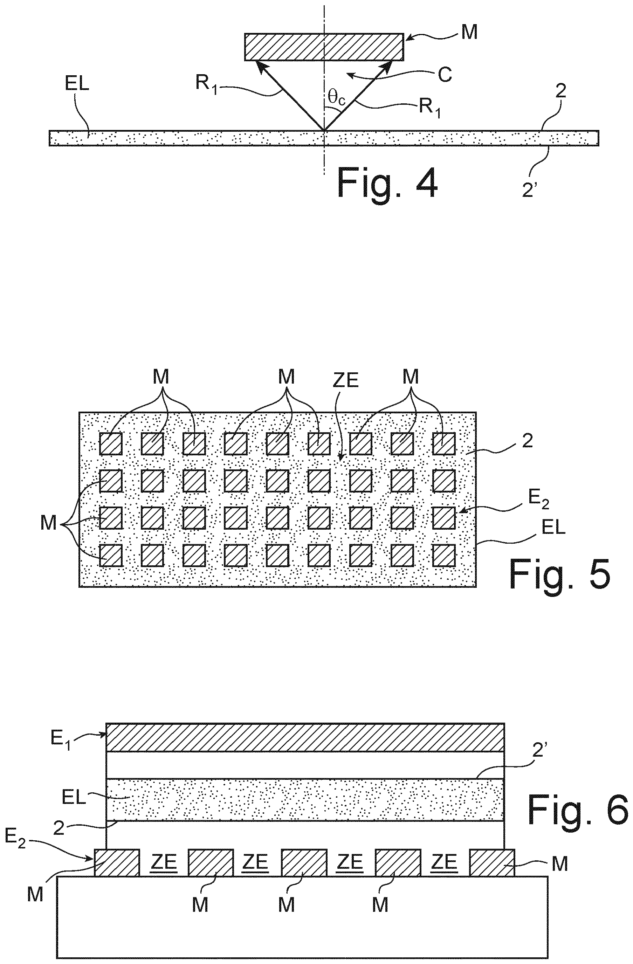

Comme illustré à la figure 4, le rayonnement électromagnétique émis par la couche électroluminescente EL comporte des rayons $R_1$, orientés vers la seconde électrode structurée Ez, formant des cônes de réfraction C présentant chacun une base. Les motifs opaques M sont avantageusement agencés de manière à recouvrir tout ou partie des bases des cônes de réfraction C. Le cône de réfraction C présente un demi-angle au sommet correspondant à l'angle critique $\theta_c$, calculé par la loi de Snell-Descartes pour la réfraction, au-delà duquel les rayons $R_1$ subissent une réflexion totale lors du passage d'un dioptre entre la couche électroluminescente EL et la seconde électrode structurée $E_2$. L'angle critique $\theta_c$ peut être de l'ordre de 35°. La propagation directe du rayonnement électromagnétique, émis depuis la couche électroluminescente EL vers la seconde électrode structurée Ez, est ainsi bloquée par les motifs opaques M de la seconde électrode structurée $E_2$.

Comme illustré à la figure 3, le rayonnement électromagnétique émis par la couche électroluminescente EL comporte des rayons $R_2$, orientés vers la première électrode $E_1$, subissant une réflexion sur la première électrode $E_1$, et se propageant ensuite à travers la zone d'espacement ZE. La propagation du rayonnement électromagnétique émis depuis la couche électroluminescente EL vers la première électrode $E_1$, et subissant une réflexion sur la première électrode, est ainsi autorisée dans la zone d'espacement ZE de la seconde électrode structurée $E_2$.

Comme illustré à la figure 5, la couche électroluminescente EL comporte une première surface émissive 2 orientée vers la seconde électrode structurée $E_2$. Plus précisément, la couche électroluminescente EL comporte des première et seconde surfaces émissives 2, 2' opposées. La première surface émissive 2 est orientée vers la seconde électrode structurée $E_2$, tandis que la seconde surface émissive 2' est orientée vers la première électrode $E_1$. Les motifs opaques M occupent avantageusement une surface totale possédant une aire comprise entre 30% et 70% de l'aire de la première surface émissive 2. Les aires des première et secondes surfaces émissives 2, 2' sont préférentiellement égales. A titre d'exemple non limitatif, chaque motif opaque M peut présenter une aire de 0,6 $\mu m^2$. Les motifs opaques M peuvent présenter une section transversale quadrangulaire (e.g. carrée, rectangulaire) ou circulaire. Cependant, d'autres formes géométriques sont envisageables pour les motifs opaques M.

Les motifs opaques M délimités par la seconde électrode structurée $E_2$ sont électriquement conducteurs. Les motifs opaques M permettent de localiser l'émission du rayonnement électromagnétique. Plus précisément, la couche électroluminescente EL comporte des zones émissives du rayonnement électromagnétique qui font face aux motifs opaques M suivant la normale aux première et seconde surfaces émissives 2, 2'.

La couche électroluminescente EL comporte des zones non-émissives du rayonnement électromagnétique qui font face à la zone d'espacement ZE suivant la normale aux première et seconde surfaces émissives 2, 2'. La seconde électrode structurée $E_2$ est avantageusement réalisée dans un matériau composite comportant une matrice métallique et un renfort en céramique (appelé aussi cermet). A titre d'exemple non limitatif, la matrice métallique peut être réalisée en Ag, et le renfort en céramique peut être réalisé en $WO_3$.

Comme illustré à la figure 8, la seconde électrode structurée $E_2$ est avantageusement revêtue d'une couche d'encapsulation 4, agencée pour protéger le dispositif de l'air et de l'humidité.

## Couche électroluminescente

La couche électroluminescente EL est avantageusement réalisée dans un matériau organique chiral. A titre d'exemples non limitatifs, le matériau organique chiral peut être :

- un hélicène, tel qu'un platinahélicène,
- le poly(fluorène-alt-benzothiadiazole) chiral (c-PFBT) -où « alt » désigne un copolymère alterné-,
- un complexe de lanthanides,
- un complexe d'iridium (III).

D'autres exemples de matériaux organiques adaptés pour émettre un rayonnement électromagnétique polarisé circulairement sont donnés dans le document J. Han et al., « Recent Progress on Circularly Polarized Luminescent Materials for Organic Optoelectronic Devices », Advanced Optical Materials, vol. 6, 17, 2018.

Le domaine spectral est avantageusement choisi parmi :

- le domaine visible avec des longueurs d'onde comprises entre 400 nm et 780 nm,
- le domaine UV-A avec des longueurs d'onde comprises entre 315 nm et 400 nm,
- le domaine infrarouge proche avec des longueurs d'onde comprises entre 780 nm et 3 $\mu m$.

La couche électroluminescente EL n'est préférentiellement pas en contact avec les première et seconde électrodes $E_1$, $E_2$. Le dispositif peut par exemple comporter des couches de transport (d'électrons et de trous) et des couches d'injection (d'électrons et de trous) s'étendant entre une électrode $E_1$, $E_2$ et la couche électroluminescente EL (dite couche émissive).

## Contrôle de l'état de polarisation

Le dispositif comporte avantageusement un réseau de diffraction en transmission 3, comprenant des motifs transparents 30 dans le domaine spectral, dimensionnés pour moduler la phase du rayonnement électromagnétique de manière à contrôler l'état de polarisation circulaire du rayonnement électromagnétique sortant du réseau de diffraction en transmission 3.

Le dimensionnement et la période des motifs transparents 30 peuvent être calculés à l'aide d'un logiciel de simulation utilisant notamment la formule des réseaux de diffraction en transmission, connue de l'homme du métier.

Le réseau de diffraction en transmission 3 peut être agencé selon une position choisie parmi :

- une première position, située entre la première électrode $E_1$ et la couche électroluminescente EL ;
- une deuxième position, située entre la couche électroluminescente EL et la seconde électrode structurée $E_2$ ;
- une troisième position, située sur la seconde électrode structurée $E_2$.

A titre d'exemple non limitatif, le réseau de diffraction en transmission 3 est agencé selon la deuxième position à la figure 8.

Le réseau de diffraction en transmission 3 peut être réalisé dans un matériau diélectrique (tel que SiOz), dans lequel des fentes sont formées périodiquement (par exemple par des techniques de photolithographie et gravure). Les fentes définissent les motifs transparents 30 du réseau de diffraction en transmission 3.

## Filtrage fréquentiel

Les motifs opaques M sont électriquement conducteurs. Comme illustré à la figure 9, la zone d'espacement ZE forme avantageusement des fentes F agencées périodiquement de sorte que la seconde électrode structurée $E_2$ possède une surface sélective en fréquence (FSS pour « *Frequency-Selective Surface* » en langue anglaise) de type filtre passe-bande. Une surface sélective en fréquence comporte des motifs périodiques planaires, formés d'éléments passifs électriquement conducteurs. Lorsque ces motifs sont soumis à une onde plane incidente, celle-ci est en partie transmise et en partie réfléchie. Une surface sélective en fréquence se comporte comme un filtre passe-bande où il est possible de filtrer certaines fréquences choisies.

Les fentes F présentent avantageusement chacune une section transversale en forme de la lettre oméga majuscule Ω de manière à créer de la chiralité. D'autres formes sont envisageables, à cet égard, les fentes F peuvent présenter une section transversale en forme d'arc de cercle, par exemple en forme de la lettre C. Le comportement électromagnétique des surfaces sélectives en fréquence est notamment décrit dans le livre édité par A. Priou et al., « Advances in Complex Electromagnetic Materials », Springer, 1997.

A titre d'exemple non limitatif, la surface sélective en fréquence peut comporter des motifs réalisés en cuivre, formés sur un substrat de polytétrafluoroéthylène (PTFE), et comportant des fentes F dont la section transversale est de préférence en forme de la lettre oméga majuscule Ω. Le substrat de PTFE peut présenter une épaisseur de 2 μm. Chaque motif de la surface sélective en fréquence peut être de forme carrée avec des côtés possédant une longueur de 15 μm.

## Architecture à émission vers le haut

Dans une architecture à émission vers le haut, comme illustré aux figures 2, 3, 7 et 8, le dispositif électroluminescent est formé sur un premier substrat $S_1$, pouvant être opaque dans le domaine spectral. A titre d'exemple non limitatif, le premier substrat $S_1$ peut être réalisé en silicium. Le rayonnement électromagnétique émis par la couche électroluminescente EL sort de la seconde électrode structurée $E_2$, à l'opposé du premier substrat $S_1$.

Le dispositif électroluminescent est formé sur le premier substrat $S_1$ par des techniques de dépôt connues de l'homme du métier. La première électrode $E_1$ peut être formée sur le premier substrat $S_1$ selon un dépôt physique en phase vapeur par pulvérisation cathodique. La couche électroluminescente EL peut être formée sur la première électrode $E_1$ selon :

- un dépôt physique en phase vapeur par évaporation sous vide,
- un dépôt chimique en phase vapeur, par exemple par un dépôt de couches atomiques (ALD pour « *Atomic Layer Déposition* » en langue anglaise). La seconde électrode $E_2$ peut être formée sur la couche électroluminescente EL à travers un pochoir pour sa structuration.

## Architecture à émission vers le bas

Dans une architecture à émission vers le bas, comme illustré à la figure 6, le dispositif électroluminescent est formé sur un deuxième substrat $S_2$, transparent dans le domaine spectral. Le rayonnement électromagnétique émis par la couche électroluminescente EL sort de la seconde électrode structurée $E_2$ puis se propage à travers le deuxième substrat $S_2$. A titre d'exemple non limitatif, le deuxième substrat $S_2$ peut être réalisé en oxyde d'indium-étain (ITO pour « *Indium Tin Oxide* » en langue anglaise).

Le dispositif électroluminescent est formé sur le deuxième substrat $S_2$ par des techniques de dépôt connues de l'homme du métier. Les première et seconde électrodes $E_1$, $E_2$ peuvent être déposées selon un dépôt physique en phase vapeur par pulvérisation cathodique. La seconde électrode $E_2$ peut être formée en utilisant des techniques de photolithographie, gravure, pour sa structuration. La couche électroluminescente EL peut être formée sur la seconde électrode $E_2$ structurée selon :

- un dépôt physique en phase vapeur par évaporation sous vide,
- un dépôt chimique en phase vapeur, par exemple par un dépôt de couches atomiques (ALD pour « *Atomic Layer Deposition* » en langue anglaise).

L'invention ne se limite pas aux modes de réalisation exposés. L'homme du métier est mis à même de considérer leurs combinaisons techniquement opérantes, et de leur substituer des équivalents L'invention est définie par les revendications.

## Revendications

1. Dispositif électroluminescent, comportant :

   - une première électrode ($E_1$), réfléchissante dans un domaine spectral ;
   - une seconde électrode ($E_2$) ;
   - une couche électroluminescente (EL), s'étendant entre les première et seconde électrodes ($E_1$, $E_2$), et adaptée pour émettre un rayonnement électromagnétique dans le domaine spectral, le rayonnement électromagnétique émis par la couche électroluminescente (EL) étant polarisé circulairement selon un premier sens de polarisation, le rayonnement électromagnétique réfléchi par la première électrode ($E_1$) étant polarisé circulairement selon un second sens de polarisation, opposé au premier sens de polarisation ;

   **caractérisé en ce que** la seconde électrode ($E_2$) est structurée de manière à délimiter :

   - des motifs opaques (M) dans le domaine spectral, agencés pour bloquer une transmission du rayonnement électromagnétique polarisé circulairement selon le premier sens de polarisation ;
   - une zone d'espacement (ZE), espaçant les motifs opaques (M) entre eux, et transparente dans le domaine spectral de manière à autoriser une transmission du rayonnement électromagnétique polarisé circulairement selon le second sens de polarisation.

2. Dispositif selon la revendication 1, dans lequel le rayonnement électromagnétique émis par la couche électroluminescente (EL) comporte des rayons ($R_1$), orientés vers la seconde électrode structurée ($E_2$), et formant des cônes de réfraction (C) présentant chacun une base ; et les motifs opaques (M) sont agencés de manière à recouvrir tout ou partie des bases des cônes de réfraction (C).

3. Dispositif selon la revendication 1 ou 2, dans lequel la couche électroluminescente (EL) comporte une première surface émissive (2) orientée vers la seconde électrode structurée ($E_2$), et les motifs opaques (M) occupent une surface totale possédant une aire comprise entre 30% et 70% de l'aire de la première surface émissive (2).

4. Dispositif selon l'une des revendications 1 à 3, dans lequel la première électrode ($E_1$) comporte des motifs réfléchissants (10) dans le domaine spectral, agencés pour former un réseau de diffraction en réflexion (1), et dimensionnés pour moduler l'amplitude du rayonnement électromagnétique de sorte que :

   - le réseau de diffraction en réflexion (1) réfléchit uniquement l'ordre zéro d'interférences du rayonnement électromagnétique,
   - le rayonnement électromagnétique sortant du réseau de diffraction en réflexion (1) se propage en incidence normale.

5. Dispositif selon l'une des revendications 1 à 4, comportant un réseau de diffraction en transmission (3), comprenant des motifs transparents (30) dans le domaine spectral, dimensionnés pour moduler la phase du rayonnement électromagnétique de manière à contrôler l'état de polarisation circulaire du rayonnement électromagnétique sortant du réseau de diffraction en transmission (3).

6. Dispositif selon la revendication 5, dans lequel le réseau de diffraction en transmission (3) est agencé selon une position choisie parmi :

   - une première position, située entre la première électrode ($E_1$) et la couche électroluminescente (EL) ;
   - une deuxième position, située entre la couche électroluminescente (EL) et la seconde électrode structurée ($E_2$) ;
   - une troisième position, située sur la seconde électrode structurée ($E_2$).

7. Dispositif selon l'une des revendications 1 à 6, dans lequel la seconde électrode structurée ($E_2$) est réalisée dans un matériau composite comportant une matrice métallique et un renfort en céramique.

8. Dispositif selon l'une des revendications 1 à 7, dans lequel les motifs opaques (M) sont électriquement conducteurs, et la zone d'espacement (ZE) forme des fentes (F) agencées périodiquement de sorte que la seconde électrode structurée ($E_2$) possède une surface sélective en fréquence de type filtre passe-bande.

9. Dispositif selon la revendication 8, dans lequel les fentes (F) présentent chacune une section transversale en forme de la lettre oméga majuscule $\Omega$.

10. Dispositif selon l'une des revendications 1 à 9, dans lequel la première électrode ($E_1$) est réalisée dans un matériau métallique.

11. Dispositif selon l'une des revendications 1 à 10, dans lequel la couche électroluminescente (EL) est réalisée dans un matériau organique chiral.

12. Dispositif selon l'une des revendications 1 à 11, dans lequel le domaine spectral est choisi parmi :

    - le domaine visible avec des longueurs d'onde comprises entre 400 nm et 780 nm,
    - le domaine UV-A avec des longueurs d'onde comprises entre 315 nm et 400 nm,
    - le domaine infrarouge proche avec des longueurs d'onde comprises entre 780 nm et 3 $\mu$m.

**Patentansprüche**

1. Elektrolumineszierende Vorrichtung, die aufweist:

    - eine erste Elektrode ($E_1$), reflektierend in einem Spektralbereich;
    - eine zweite Elektrode ($E_2$);
    - eine elektrolumineszierende Schicht (EL), die sich zwischen den ersten und zweiten Elektroden ($E_1$, $E_2$) erstreckt und geeignet ist, eine elektromagnetische Strahlung im Spektralbereich zu emittieren, wobei die von der elektrolumineszierenden Schicht (EL) emittierte elektromagnetische Strahlung gemäß einer ersten Polarisationsrichtung zirkular polarisiert ist, wobei die von der ersten Elektrode ($E_1$) reflektierte elektromagnetische Strahlung gemäß einer zweiten Polarisationsrichtung entgegengesetzt zur ersten Polarisationsrichtung zirkular polarisiert ist;
    - **dadurch gekennzeichnet, dass** die zweite Elektrode ($E_2$) strukturiert ist, um zu begrenzen:

        - opake Muster (M) im Spektralbereich, die angeordnet sind, um eine Übertragung der gemäß der ersten Polarisationsrichtung zirkular polarisierten elektromagnetischen Strahlung zu blockieren;
        - eine Abstandszone (ZE), die die opaken Muster (M) zueinander beabstandet und im Spektralbereich transparent ist, um eine Übertragung der gemäß der zweiten Polarisationsrichtung zirkular polarisierten elektromagnetischen Strahlung zu erlauben.

2. Vorrichtung nach Anspruch 1, wobei die von der elektrolumineszierenden Schicht (EL) emittierte elektromagnetische Strahlung Strahlen ($R_1$) aufweist, die zur strukturierten zweiten Elektrode ($E_2$) gerichtet sind und Brechungskegel (C) bilden, die je eine Basis aufweisen; und die opaken Muster (M) so angeordnet sind, dass sie die Basen der Brechungskegel (C) ganz oder teilweise bedecken.

3. Vorrichtung nach Anspruch 1 oder 2, wobei die elektrolumineszierende Schicht (EL) eine erste emittierende Fläche (2) aufweist, die zur strukturierten zweiten Elektrode ($E_2$) gerichtet ist, und die opaken Muster (M) eine Gesamtfläche einnehmen, die einen Flächeninhalt besitzt, der zwischen 30% und 70% des Flächeninhalts der ersten emittierenden Fläche (2) liegt.

4. Vorrichtung nach einem der Ansprüche 1 bis 3, wobei die erste Elektrode ($E_1$) reflektierende Muster (10) im Spektralbereich aufweist, die angeordnet sind, um ein Reflexionsbeugungsgitter (1) zu bilden, und bemessen sind, um die Amplitude der elektromagnetischen Strahlung zu modulieren, so dass:

    - das Reflexionsbeugungsgitter (1) nur die nullte Ordnung von Interferenzen der elektromagnetischen Strahlung reflektiert,
    - die aus dem Reflexionsbeugungsgitter (1) austretende elektromagnetische Strahlung sich im Senkrechteinfall ausbreitet.

5. Vorrichtung nach einem der Ansprüche 1 bis 4, die ein Transmissionsbeugungsgitter (3) aufweist, das transparente Muster (30) im Spektralbereich enthält, die bemessen sind, die Phase der elektromagnetischen Strahlung zu modulieren, um den Zustand zirkularer Polarisation der aus dem Transmissionsbeugungsgitter (3) austretenden elektromagnetischen Strahlung zu steuern.

6. Vorrichtung nach Anspruch 5, wobei das Transmissionsbeugungsgitter (3) gemäß einer Position angeordnet ist, die ausgewählt wird unter:

    - einer ersten Position, die sich zwischen der ersten Elektrode ($E_1$) und der elektrolumineszierenden Schicht (EL) befindet;
    - einer zweiten Position, die sich zwischen der elektrolumineszierenden Schicht (EL) und der strukturierten zweiten Elektrode ($E_2$) befindet;
    - einer dritten Position, die sich auf der strukturierten zweiten Elektrode ($E_2$) befindet.

7. Vorrichtung nach einem der Ansprüche 1 bis 6, wobei die strukturierte zweite Elektrode ($E_2$) aus einem Verbundmaterial hergestellt wird, das eine metallische Matrix und eine Verstärkung aus Keramik aufweist.

8. Vorrichtung nach einem der Ansprüche 1 bis 7, wobei die opaken Muster (M) elektrisch leitend sind und die Abstandszone (ZE) Schlitze (F) bildet, die periodisch so angeordnet sind, dass die strukturierte zweite Elektrode (E$_2$) eine frequenzselektive Fläche vom Typ Bandpassfilter besitzt.

9. Vorrichtung nach Anspruch 8, wobei die Schlitze (F) je einen Querschnitt in Form des Großbuchstabens Omega $\Omega$ aufweisen.

10. Vorrichtung nach einem der Ansprüche 1 bis 9, wobei die erste Elektrode (E$_1$) aus einem metallischen Material hergestellt ist.

11. Vorrichtung nach einem der Ansprüche 1 bis 10, wobei die elektrolumineszierende Schicht (EL) aus einem chiralen organischen Material hergestellt ist.

12. Vorrichtung nach einem der Ansprüche 1 bis 11, wobei der Spektralbereich ausgewählt wird aus:

    - dem sichtbaren Bereich mit Wellenlängen zwischen 400 nm und 780 nm,
    - dem UV-A-Bereich mit Wellenlängen zwischen 315 nm und 400 nm,
    - dem nahen Infrarotbereich mit Wellenlängen zwischen 780 nm und 3 $\mu$m.

**Claims**

1. Light-emitting device, comprising:

    - a first electrode (E$_1$), reflecting in a spectral range;
    - a second electrode (E$_2$);
    - a light-emitting layer (EL), extending between the first and second electrodes (E$_1$, E$_2$), and adapted to emit electromagnetic radiation in the spectral range, the electromagnetic radiation emitted by the light-emitting layer (EL) being circularly polarized in a first polarization direction, the electromagnetic radiation reflected by the first electrode (E$_1$) being circularly polarized in a second polarization direction, opposite to the first polarization direction;

**characterized in that** the second electrode (E$_2$) is structured so as to define:

    - opaque patterns (M) in the spectral range, arranged to block transmission of the circularly polarized electromagnetic radiation in the first polarization direction;
    - a spacing zone (ZE), spacing apart the opaque patterns (M) from one another, and transparent in the spectral range so as to allow transmission of the circularly polarized electromagnetic radiation in the second polarization direction.

2. Device according to Claim 1, wherein the electromagnetic radiation emitted by the light-emitting layer (EL) comprises rays (R$_1$), oriented toward the second structured electrode (E$_2$), and forming refraction cones (C) each having a base; and the opaque patterns (M) are arranged so as to cover all or part of the bases of the refraction cones (C).

3. Device according to Claim 1 or 2, wherein the light-emitting layer (EL) comprises a first emissive surface (2) oriented toward the second structured electrode (E$_2$), and the opaque patterns (M) occupy a total surface area having an area ranging between 30% and 70% of the area of the first emissive surface (2).

4. Device according to any of Claims 1 to 3, wherein the first electrode (E$_1$) comprises reflective patterns (10) in the spectral range, arranged to form a reflection diffraction grating (1), and dimensioned to modulate the amplitude of the electromagnetic radiation such that:

    - the reflection diffraction grating (1) reflects only the zero order of interference of the electromagnetic radiation;
    - the electromagnetic radiation exiting the reflection diffraction grating (1) propagates at normal incidence.

5. Device according to any of Claims 1 to 4, comprising a transmission diffraction grating (3), comprising transparent patterns (30) in the spectral range, dimensioned to modulate the phase of the electromagnetic radiation so as to control the circular polarization state of the electromagnetic radiation exiting the transmission diffraction grating (3).

6. Device according to Claim 5, wherein the transmission diffraction grating (3) is arranged in a position selected from among:

    - a first position, located between the first electrode (E$_1$) and the light-emitting layer (EL);
    - a second position, located between the light-emitting layer (EL) and the second structured electrode (E$_2$);
    - a third position, located on the second structured electrode (E$_2$).

7. Device according to any of Claims 1 to 6, wherein the second structured electrode (E$_2$) is made of a composite material comprising a metal matrix and a ceramic reinforcement.

8. Device according to any of Claims 1 to 7, wherein the opaque patterns (M) are electrically conductive, and the spacing zone (ZE) forms slits (F) periodically arranged so that the second structured electrode (E$_2$) has a band-pass filter type frequency selective surface.

9. Device according to Claim 8, wherein the slits (F) each have a cross-section in the form of an upper-case omega $\Omega$.

10. Device according to any of Claims 1 to 9, wherein the first electrode (E$_1$) is made of a metal material.

11. Device according to any of Claims 1 to 10, wherein the light-emitting layer (EL) is made of a chiral organic material.

12. Device according to any of Claims 1 to 11, wherein the spectral range is selected from among:

> - the visible range with wavelengths ranging between 400 nm and 780 nm;
> - the UV-A range with wavelengths ranging between 315 nm and 400 nm;
> - the near-infrared range with wavelengths ranging between 780 nm and 3 $\mu$m.

Fig. 1

Fig. 2

Fig. 3

Fig. 4

Fig. 5

Fig. 6

Fig. 7

Fig. 8

Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- KR 20190075218 A
- JP 2000195673 A
- US 20111001905 A1
- US 8247834 B2

**Littérature non-brevet citée dans la description**

- **ZINNA et al.** Higbly Circularly Polarized Electroluminescence from a Chiral Europium Complex. *Advanced Materials,* 2015, vol. 27 (10
- **J. HAN et al.** Recent Progress on Circularly Polarized Luminescent Materials for Organic Optoelectronic Devices. *Advanced Optical Materials,* 2018, vol. 6, 17
- **A. PRIOU et al.** Advances in Complex Electromagnetic Materials. Springer, 1997